Europäisches Patentamt

European Patent Office

Office européen des brevets

(11) Publication number: **0 055 908**
**B1**

## (12) EUROPEAN PATENT SPECIFICATION

(45) Date of publication of patent specification: **09.09.87**

(21) Application number: **81305942.5**

(22) Date of filing: **18.12.81**

(51) Int. Cl.⁴: **H 03 K 19/003,**
H 03 K 19/088, H 03 K 19/084

(54) Bipolar logic circuit.

(30) Priority: **25.12.80 JP 184561/80**
**26.12.80 JP 188937/80**

(43) Date of publication of application:
**14.07.82 Bulletin 82/28**

(45) Publication of the grant of the patent:
**09.09.87 Bulletin 87/37**

(84) Designated Contracting States:
**DE FR GB**

(56) References cited:
**US-A-3 317 753**
**US-A-3 979 607**

**ELECTRONICS, Vol.53, No. 5, February 1980,**
**New York, P.HOFFPAUIR "LS2 Family Squeezes**
**More Speed from Existing TTL Sockets" pages**
**149 to 153**

(73) Proprietor: **FUJITSU LIMITED**
**1015, Kamikodanaka Nakahara-ku**
**Kawasaki-shi Kanagawa 211 (JP)**

(72) Inventor: **Ueno, Kouji**
**1360, Shukugawara Tama-ku**
**Kawasaki-shi Kanagawa 214 (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

## Description

This invention relates to a bipolar logic circuit.

A defect of previously proposed logic circuits, which involves the disturbance of an output waveform as a result of the influence of adjacent circuits and parasitic capacitance, will be explained with reference to the following drawings;

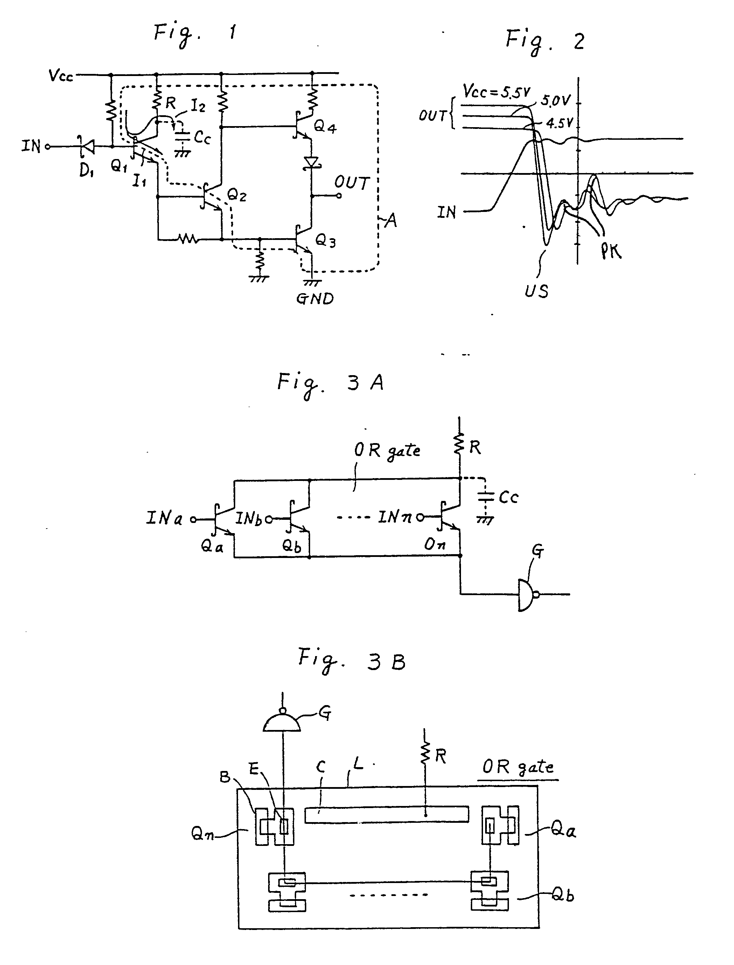

Fig. 1 of the accompanying drawings is a circuit diagram of a previously proposed bipolar logic circuit, Fig. 2 is a waveform diagram showing an output waveform of the logic circuit of Fig. 1, Fig. 3A is a circuit diagram of a circuit having a large collector capacitance, and Fig. 3B illustrates a pattern arrangement corresponding to the circuit of Fig. 3A.

In Fig. 1, a diode $D_1$ has a forward voltage $V_F$ of 0.4 (V) and transistors $Q_1$ to $Q_3$ have a $V_{BE}$ of 0.8 V and a threshold voltage of 2.0 (V), for example. If an input voltage IN is higher than 2.0 (V), base current for the transistor $Q_2$ is supplied from the transistor $Q_1$, the first stage transistor, to the transistor $Q_2$, the next stage transistor, through the emitter of the transistor $Q_1$. The transistor $Q_2$ is turned on, whereby base current for the transistor $Q_3$, the output stage transistor, is supplied from the emitter of the transistor $Q_2$. As a result, the transistor $Q_3$ is turned on. At the same time, the collector potential of the transistor $Q_2$ falls, thus turning off another transistor $Q_4$, another output stage transistor. In consequence an output OUT of the logic circuit falls to L level. Conversely, if input voltage IN is lower than 2.0 (V) the transistors $Q_1$, $Q_2$ and $Q_3$ are turned off and only the transistor $Q_4$ is turned on, whereby the output OUT rises to H level.

If a logic circuit of this type is fabricated in a high speed and high packing density integrated circuit, the waveform of the output OUT is deformed in some instances, being affected by parasitic or stray capacitance or the like. In particular, it is quite possible that when the output OUT falls from H level to L level, one or more peaks PK follow as shown in Fig. 2, thus deforming the waveform of the output OUT. Fig. 2 is a representation of an oscilloscope waveform showing how the output OUT changes, with $V_{CC}$ as parameter. It also illustrates the waveform of the input IN. In the circuit of Fig. 1 the polarity of the input IN is opposite to that of the output OUT.

The cause of the one or more peaks PK can be attributed to many factors. One factor is the collector capacitance of a transistor used. More precisely, since the first stage transistor $Q_1$ has a large capacitance Cc, indicated in Fig. 1, an oscillation occurs in a loop A (indicated by a broken line) which feeds the output OUT back to the input terminal through the base and emitter of the transistors $Q_1$ and $Q_2$ and which is capable of amplifying current. In consequence, such peaks PK as are shown in Fig. 2 are generated.

This undesirable phenomenon is prominent in, for example, a circuit such as is shown in Fig. 3A. In this circuit a plurality of transistors $Q_a$—$Q_n$ have their emitters commonly connected and their collectors commonly connected, thus constituting a logical OR gate. The bases of the transistors $Q_a$—$Q_n$ are connected to receive respective inputs $IN_a$—$IN_n$. The output of the logical OR gate is coupled to a gate G. If the circuit of Fig. 3A is fabricated as an integrated circuit, the integrated circuit will have a pattern such as is shown in Fig. 3B. That is, the transistors $Q_a$—$Q_n$ will be formed in the same island L, which functions as a collector common to all the transistors $Q_a$—$Q_n$. Therefore it is natural that the capacitance $C_c$ of the common collector is very large. In Fig. 3B, a collector electrode is indicated as C, E represents an emitter electrode and B designates a base electrode.

When the transistor $Q_1$ of the circuit shown in Fig. 1 is one of the transistors $Q_a$—$Q_n$ shown in Fig. 3B, the collector capacitance of the transistor $Q_1$ is large. In this event the waveform of the output OUT of the circuit of Fig. 1 has peaks PK.

It will now be described more in detail why the output OUT has such peaks PK as are shown in Fig. 2.

If the transistor $Q_1$ for amplifying current has a large collector capacitance $C_c$ (e.g. a large parasitic capacitance), the input current supplied to the base is, as shown in Fig. 1, divided into a current $I_1$ flowing to the emitter and current $I_2$ flowing to the collector when the input IN rises from L level to H level. Since the collector capacitance $C_c$ of the transistor $Q_1$ is large, a time constant $C_c \cdot R$ of the transistor $Q_1$ is large proportionally and the collector potential of the transistor $Q_1$ inevitably undergoes so called undershoot operation (indicated by US in Fig. 2). In a case in which there is delay in recovering from the under-shoot operation, the base current of the transistor $Q_1$ so flows as to charge the capacitance $C_c$. As the result, the transistor $Q_1$ will be turned off. Once the transistor $Q_1$ is turned off, its collector potential starts rising again. In this way the collector potential falls and rises repeatedly. Consequently, a pulsating current flows through the emitter of the transistor $Q_1$. The pulsating output current of the transistor $Q_1$ is amplified by the transistor $Q_2$, which generates a larger pulsating current. The output current of the transistor $Q_2$ is then amplified by the transistor $Q_3$, which generates a still larger pulsating current. The output current of the transistor $Q_3$ is amplified by the transistor $Q_4$. As a result, the output OUT has a waveform similar to that of the emitter current of the transistor $Q_1$. Obviously, it has several peaks PK.

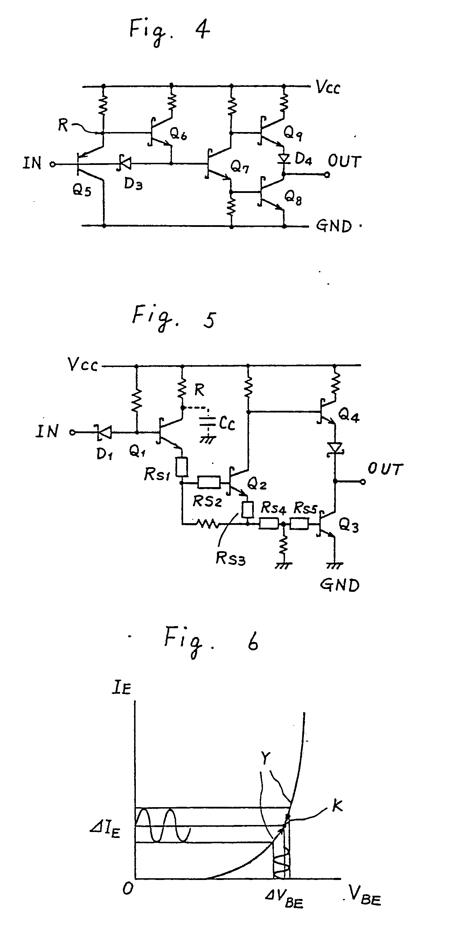

A further defect of previously proposed bipolar logic circuits will be explained with reference to Fig. 4 of the accompanying drawings, which is a circuit diagram of a TTL circuit.

Usually, the input threshold voltage $V_{th}$ of a TTL circuit is specified by the sum of base-emitter voltages $V_{BE}$ of transistors used in the circuit and/ or the forward voltage or voltages $V_F$ for a diode or diodes. No distinction is made hereinafter.

In the circuit of Fig. 4, the transistors $Q_5$ to $Q_8$ determine the input threshold voltage $V_{th}$. The

potential of a point R is the sum of the $V_{BE}$'s of the transistors $Q_6$ to $Q_8$ ($V_{BE6}$ to $V_{BE8}$) and the input IN is at potential lower by one $V_{BE}$ ($V_{BE5}$). Thereby, the level of output OUT is determined according to whether the input voltage is higher or lower than such input threshold voltage $V_{th}$.

The threshold voltage $V_{th}$ of the TTL circuit shown in Fig. 4 is expressed by the following equation.

$$V_{th}=V_{BE6}+V_{BE7}+V_{BE8}-V_{BE5} \qquad (1)$$

Therefore, the $V_{BE}$'s of the transistors must be changed in order to change the threshold voltage. However, the $V_{BE}$ of a transistor is specified by the emitter size and is usually selected within the range from 0.7 to 0.8 V. For example, when the $V_{BE}$'s of the transistors are equal, $V_{th}$ can be selected only within the range from 1.4 to 1.6 V. In addition, it is also possible to vary the $V_{BE}$'s of the transistors but the range of variation of threshold voltage is still limited and production processes must be changed. Therefore, it is undesirable to vary the $V_{BE}$'s of the transistors.

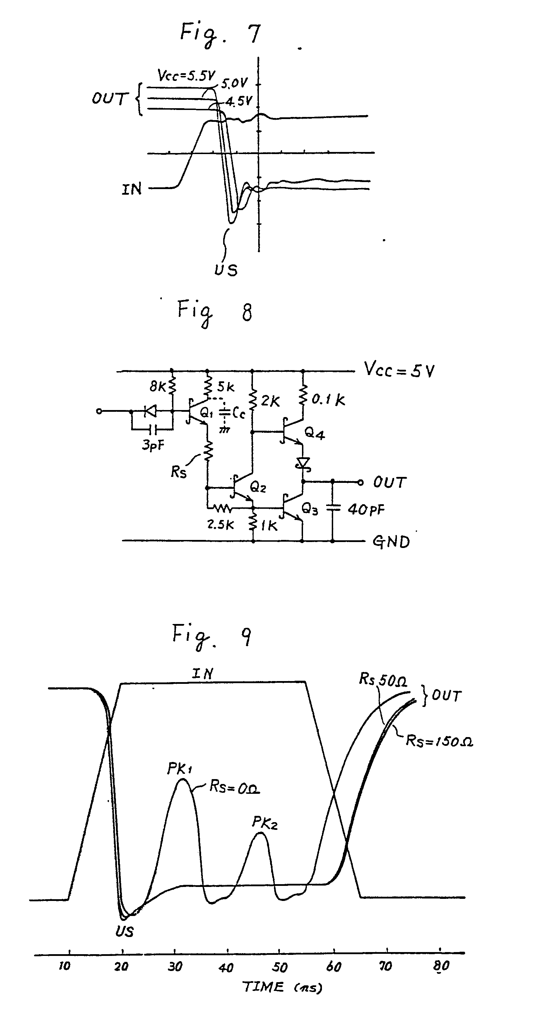

Electronics, vol. 53 (1980) Feb. No. 5, pages 149 to 153, "LS$^2$ Family Squeezes more Speed from Existing TTL Sockets", discloses at Fig. 6(b) a bipolar logic circuit in which an input is delivered to the base of a transistor $Q_1$ via a diode $D_1$. The emitter of transistor $Q_1$ is connected to the base of a transistor $Q_2$ by way of a resistor $R_3$ which limits the gain of $Q_1$.

According to the present invention there is provided a bipolar TTL or DTL logic circuit, having an input stage, a phase splitter transistor and an output stage, and having a resistance provided in the current path in the circuit, connecting the input stage to the phase splitter transistor which determines the input threshold voltage of the logic circuit, a constant current source being connected between the said resistance and a power source voltage line so that current flowing through the constant current source is supplied to the said resistance whereby the voltage drop across said resistance is determined by the current flowing through the constant current source, so that the input threshold voltage of the logic circuit is determined in dependence upon the value of the said resistance and the value of the current flowing through the constant current source when the logic circuit is in use, the base of the phase-splitter transistor being connected to the common connection part of the said resistance and the constant current source, and the output stage including an output transistor having its base connected to the emitter of the phase splitter transistor.

An embodiment of the present invention can provide a TTL or DTL circuit which has stable output waveforms, and can provide for the free setting of input threshold voltage.

An embodiment of the present invention can provide a bipolar logic circuit which prevents disturbance of output waveforms as a result of the influence of adjacent circuits and parasitic capacitance and which provides a stable waveform.

An embodiment of the present invention can provide a bipolar logic circuit with stable output waveforms by the addition of only a simplified circuit, and can provide for free selection of threshold voltage.

Reference is made, by way of example, to the accompanying drawings, in which:—

Fig. 1 is a circuit diagram of a previously proposed bipolar logic circuit,

Fig. 2 is a waveform diagram showing an output waveform of the bipolar logic circuit of Fig. 1,

Fig. 3A is a circuit diagram of a circuit having a large collector capacitance,

Fig. 3B illustrates a pattern arrangement corresponding to the circuit shown in Fig. 3A,

Fig. 4 is a circuit diagram of a previously proposed TTL circuit,

Fig. 5 is a circuit diagram for assistance in explanation of the present invention,

Fig. 6 is a graph illustrating the relationship between emitter current and base-emitter voltage of a transistor used in the circuit of Fig. 5, for assistance in explanation of the present invention,

Fig. 7 is a waveform diagram illustrating an output waveform of the circuit shown in Fig. 5,

Fig. 8 is a circuit diagram for assistance in explanation of the present invention,

Fig. 9 is a waveform diagram illustrating output waveforms of the circuit shown in Fig. 8,

Figs. 10(a) and 10(b) are circuit diagrams of different circuit forms for further assistance in explanation of the present invention,

Fig. 11 is another circuit diagram for assistance in explanation of the present invention,

Fig. 12 is a schematic circuit diagram illustrating an embodiment of the present invention,

Fig. 13 is a graphical representation of input/output transfer characteristics of the embodiment of the present invention shown in Fig. 12,

Fig. 14 is a circuit diagram illustrating a form of the embodiment of the present invention shown in Fig. 12,

Fig. 15 to Fig. 17 are circuit diagrams for assistance in explanation of further embodiments of the present invention, Figures marked (a) illustrate previously proposed circuits whilst Figures marked (b) illustrate generally corresponding embodiments of the present invention, and

Fig. 18 and Fig. 19 are circuit diagrams illustrating respective examples of current sources employed in further embodiments of the present invention.

Figs. 5 to 11 illustrate bipolar logic circuits so formed as to prevent disturbance of output waveforms.

The circuit of Fig. 5 is similar to the circuit of Fig. 1, except that resistances $R_{S1}$ and $R_{S2}$ are connected in series between the emitter of a transistor $Q_1$ and the base of a transistor $Q_2$ and except that resistances $R_{S3}$, $R_{S4}$ and $R_{S5}$ are connected in series between the emitter of the tran-

sistor $Q_2$ and the base of a transistor $Q_3$. The resistances $R_{S1}$—$R_{S5}$ are used to stabilise the output signals of the transistors $Q_1$ and $Q_2$. Alternatively, only one resistance may be connected between the emitter of the current amplifying transistor $Q_1$ and the base of the next-stage transistor $Q_2$ and/or only one resistance may be connected between the emitter of the transistor $Q_2$ and the base of the next-stage transistor $Q_3$.

The resistances $R_{S1}$—$R_{S5}$ are so connected as mentioned above in order to apply negative feedback on input signals to the transistors $Q_1$, $Q_2$ and $Q_3$.

It will now be described how the resistor $R_{S1}$ functions, with reference to Fig. 6.

Fig. 6 illustrates the relationship between emitter current $I_E$ and base-emitter voltage $V_{BE}$ of the transistor $Q_1$. A voltage drop is created at the resistance $R_{S1}$ in the opposite direction to and in response to a variation $\Delta I_E$ of the emitter current. This voltage drop suppresses variation of the emitter current $I_E$. When the emitter current $I_E$ changes by $\Delta I_E$, the base-emitter voltage $V_{BE}$ changes by $\Delta V_{BE}$. The resistance $R_{S1}$ reduces the change $\Delta V_{BE}$. As a result, the base-emitter voltage $V_{BE}$ varies in the directions of arrows Y and ultimately reaches a stable point K. That is, even if the transistor $Q_1$ generates a pulsating current, the resistance $R_{S1}$ reduces the peaks of the pulsating current. All the other resistances $R_{S2}$—$R_{S5}$ perform the same function as the resistance $R_{S1}$.

The resistances of $R_{S1}$—$R_{S5}$ must be determined according to the value of a current which flows in the circuit including the resistances $R_{S1}$—$R_{S5}$. For example, they are determined according to the impedance of the circuit including the resistances $R_{S1}$—$R_{S5}$ so that the voltage $V_{RS}$ between the resistance $R_{S1}$ and the resistance $R_{S5}$ may lie in the range 50 mV to 100 mV. If the voltage $V_{RS}$ is normally 60 mV, variation of the voltage $V_{BE}$ can be fully compensated even if the variation is so large that the emitter current $I_E$ would be reduced in about 1/10. Hence the emitter current $I_E$ can remain stable and constant.

Fig. 7 shows the waveform of the output OUT which is generated in a case in which only the resistance $R_{S1}$ is used and has a resistance of 110 Ω. The condition of input IN in Fig. 7 is similar to that illustrated in Fig. 2. In Fig. 7 outputs OUT of different levels, with $V_{CC}$ as parameter, are shown. As is evident from Fig. 7, no peaks are generated after an under-shoot US has taken place.

In the circuit of Fig. 8 a stabilising resistor $R_S$ is connected between the emitter of transistor $Q_1$ and the base of transistor $Q_2$. Fig. 9 shows calculated values representing waveforms which the output OUT of the circuit may have when the stabilising resistor $R_S$ in Fig. 8 is set to various resistance values. As will be clearly understood from Fig. 9, when the resistance of the resistor $R_S$ is 0 Ω, (i.e. when no stabilising resistor is provided) the circuit generates an output OUT having the same waveform as the output OUT of the circuit shown in Fig. 1. It is a good assumption that this output OUT has two peaks $PK_1$ and $PK_2$. When the resistance of the resistor $R_S$ is 50 Ω or 150 Ω, the circuit generates an output OUT which has no peaks whatsoever. Indeed the output OUT may be delayed due to the stabilising resistor $R_S$. This delay is negligibly small and no problem is experienced in practice if the resistance of the resistor $R_S$ is about 10% or less of the impedance of the whole circuit.

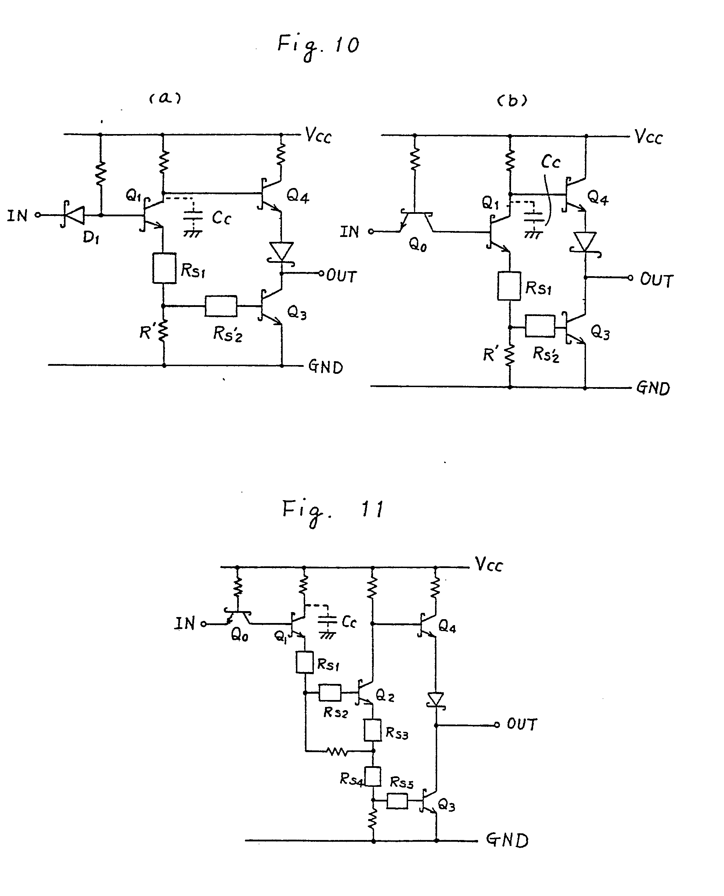

Fig. 10 shows two forms of circuit (a) and (b), respectively. The circuit of Fig. 10(a) is a DTL circuit, and the circuit of Fig. 10(b) is a TTL circuit. Each circuit uses two current stabilising resistors $R_{S1}$ and $R_{S'2}$. In each case the resistor $R_{S1}$ is connected between the emitter of a transistor $Q_1$ and a resistor R', and the resistor $R_{S'2}$ is connected between the resistor R' and the base of a transistor $Q_3$. It is not necessary to use both resistors $R_{S1}$ and $R_{S'2}$. Any one of them can serve to stabilise the output of either the DTL circuit or the TTL circuit to a sufficient degree.

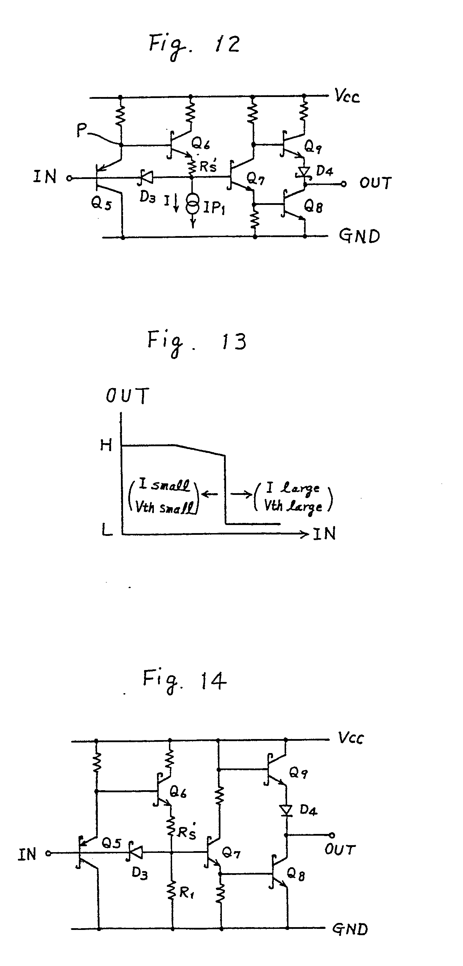

The circuit of Fig. 11 is identical with the circuit of Fig. 5 except that a transistor $Q_0$ is connected to receive an input signal, in place of diode $D_1$. In the circuit of Fig. 11 all the current stabilising resistances $R_{S1}$—$R_{S5}$ need not be used. It is sufficient to use at least one current stabilising resistance.

The embodiments of the present invention described below utilise at least one stabilising resistance as explained above, and moreover are capable of providing for easy changing of the threshold voltage $V_{th}$ of a bipolar logic circuit such as TTL or DTL circuit. These embodiments of the present invention will be explained in detail with reference to the embodiments shown in Figs. 12 to 19.

Fig. 12 illustrates an embodiment of the present invention applied to a TTL circuit similar in form to that of Fig. 4. The threshold voltage $V_{th}$ of the TTL circuit of Fig. 12 can be changed over a wide range by means of a resistor $R'_S$ which is inserted in series into the path extending from the emitter of transistor $Q_6$ to the base of transistor $Q_7$, called the phase splitter, and a constant current source $IP_1$ which supplies a current I. In the TTL circuit of Fig. 12, a voltage $V_{RS}'$ generated by the resistor $R_{S'}$ is included in the input threshold voltage $V_{th}$. Therefore, the input threshold voltage $V_{th}$ is expressed by the following equation:—

$$V_{th}=V_{BE6}+V_{BE7}+V_{BE8}+V_{RS'}-V_{BE5} \qquad (2)$$

and

$$V_{RS'}=I\ R_{S'} \qquad (3)$$

A base current for transistor $Q_7$ flows when the transistors $Q_8$, $Q_9$ turn on, but it is sufficiently low to be ignored for values near $V_{th}$.

The minimum value $V_{th(min)}$ of $V_{th}$ which can be achieved in accordance with equation (2) can be expressed by the equation (4), which is the same as equation (1), since $V_{th(min)}$ is obtained when R=O or I=O.

$$V_{th(min)} = V_{BE6} + V_{BE7} + V_{BE8} - V_{BE5} \qquad (4)$$

On the other hand, the maximum value $V_{th(max)}$ of $V_{th}$ can be set as high as the power source voltage $V_{cc}$, but is properly expressed by equation (5) when a margin $V_{thM}$ allowing the TTL circuit to be turned ON stably is considered.

$$V_{th(max)} = V_{cc} - V_{thM} \qquad (5)$$

In general, it is recommended to set $V_{thM}$ to a value 1.6 V which is the value of two stages or higher with $V_{BE}$ being set almost to 0.8 V ($V_{BE}$=0.8 V).

The operation of the TTL circuit of Fig. 12 is similar to the operation of the circuit of Fig. 1. When input voltage to the transistor $Q_5 > V_{th}$, the transistor $Q_5$ turns OFF, transistors $Q_6$ to $Q_8$ turn ON and $Q_9$ turns OFF. Thereby output OUT becomes L. On the other hand, when input voltage $< V_{th}$, the transistor $Q_5$ turns ON, transistors $Q_6$ to $Q_8$ turns OFF and $Q_9$ becomes ON. Thereby output OUT becomes H.

Figure 13 illustrates input/output transfer characteristics where the operating point of the output OUT, namely the threshold voltage $V_{th}$ of the input IN, becomes small, with $V_{th(min)}$ of equation (4) considered as the lower limit, when the current I or resistance $R_s'$ is set small, and where the operating point becomes large, on the other hand, with $V_{th(max)}$ of equation (5) considered as the upper limit, when the I or $R_s'$ is set large.

In Fig. 12, $D_3$ is a speed-up diode which extracts base charges from the transistor $Q_7$, and $D_4$ is a level shift diode for output OUT. The resistor $R_s'$ inserted in the path extending from the emitter of the transistor $Q_6$ to the base of transistor $Q_7$ and also plays a role, as explained above, as a stabilising resistor for the output waveform.

Figure 14 is the schematic diagram indicating a modification of Fig. 12 in which the current source is realised with a very simple structure, the resistor $R_1$.

In Fig. 14, when the transistor $Q_5$ is OFF, the transistors $Q_6$ to $Q_8$ are ON, whilst $Q_9$ is OFF. Therefore the output OUT is at L level. At this time, a voltage which is equal to the sum of the $V_{BE}$'s of the transistors $Q_7$ and $Q_8$, $V_{BE7} + V_{BE8}$, is applied across the resistor $R_1$ and a current I, $(V_{BE7} + V_{BE8})/R_7$ flows through this resistor $R_1$. Since $V_{BE7}$, and $V_{BE8}$ change little, the current I becomes constant and the resistor $R_1$ operates as a constant current source.

On the other hand, when the transistor $Q_5$ is ON, the transistors $Q_6$ to $Q_8$ become OFF. Therefore, no voltage is applied across the resistor $R_1$ and the resistor $R_1$ can be ignored.

When the current source $IP_1$ is formed by a resistor as in Fig. 14, the input threshold voltage $V_{th}$ can be set merely by providing two resistors $R_s'$ and $R_1$ having selected resistance values.

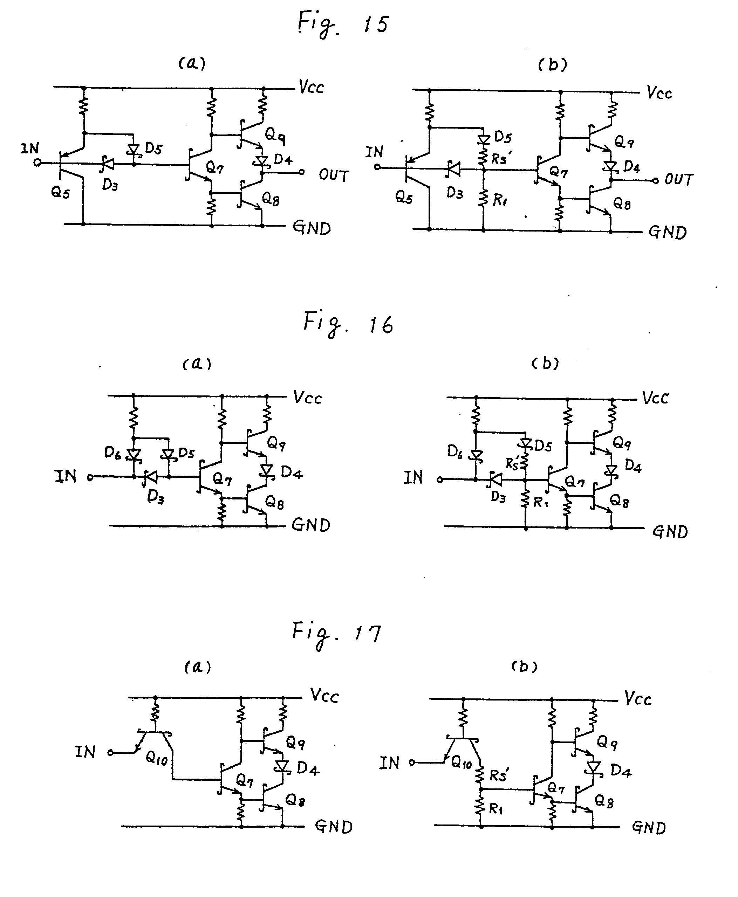

The TTL circuit of Fig. 12 can be roughly divided into an input stage including transistors $Q_5$, $Q_6$ and an invertor including transistors $Q_7$ to $Q_9$. The input stage can take various modified forms as shown in Figs. 15 to Fig. 17, and the structure of the invertor is not limited only to that shown in Fig. 12.

Fig. 15(a) to Fig. 17(a) are schematic circuit diagrams of the respective previously proposed TTL or DTL circuits which differ only in their input stages, whilst Fig. 15(b) to Fig. 17(b) are schematic diagrams of respective further embodiments of the present invention corresponding in general terms to circuits of Figures 15(a) to 17(a) respectively.

In Fig. 15(a), the transistor $Q_6$ (of Fig. 12 or Fig. 4) of the input stage is replaced by a diode $D_5$ and the forward voltage of the diode has effect. In a corresponding circuit embodying the present invention, as shown in Fig. 15(b), the resistor $R_s'$ is inserted between the cathode of diode $D_5$ and the base of transistor $Q_7$, whilst the resistor $R_1$ is inserted between the base and earth GND. The threshold voltage $V_{th}$ can be set as in the case of Fig. 14 merely be selecting the values of resistor $R_s'$ or $R_1$.

In Fig. 16(a), the transistor $Q_5$ of Fig. 15(a) is replaced by a diode $D_6$, thus forming an input stage. In this case, connection of the resistors $R_s'$ and $R_1$ in the corresponding circuit embodying the present invention is the same as is shown in Fig. 15(b) as indicated in Fig. 16(b).

Figure 17(a) illustrates an input stage in which the diodes $D_5$, $D_6$ of Fig. 16(a) are replaced by one npn transistor $Q_{10}$. The diode $D_3$ is omitted. As shown in Fig. 17(b), in the corresponding circuit embodying the present invention the resistor $R_s'$ is connected between the collector of transistor $Q_{10}$ and the base of transistor $Q_7$, whilst the resistor $R_1$ is connected between the said base and the earth GND.

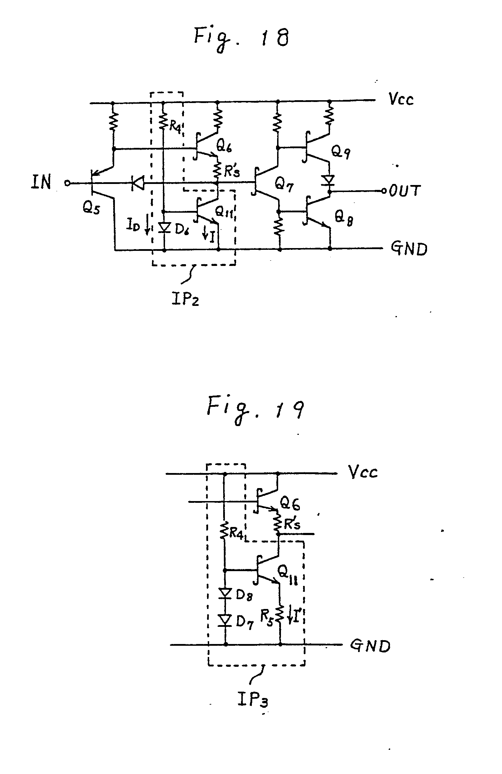

In each of the embodiments, a resistor $R_s'$ is inserted between the input stage and the invertor. Since the threshold voltage $V_{th}$, as explained above, is determined by the total of the $V_{BE}$'s within the circuit, as viewed from the input IN, it is possible to insert a corresponding resistor in a different location, so long as the location is selected to lie within the path which determines the threshold voltage $V_{th}$. In addition, the current source $IP_1$ shown in Fig. 12 can be realised most easily as a resistor but it goes without saying that the current source can naturally be formed by any other desirable method, for example as shown in Fig. 18 and Fig. 19.

Fig. 18 illustrates another embodiment of the present invention, of which the circuit is identical to that of Fig. 14 except for the structure of the current source $IP_2$ bounded by broken lines in Fig. 18. In Fig. 18, current source $IP_2$ is formed by a diode $D_6$ and a resistor $R_4$, which are connected in series between power source Vcc and GND, and a transistor $Q_{11}$ whose base is connected to the anode of the diode $D_6$. The current I flowing through transistor $Q_{11}$ is the same as the current $I_D$ flowing through the diode $D_6$ in Fig. 18. Therefore, the current I is expressed by the following equation. ($V_F$ is forward voltage of the diode $D_6$)

$$I = I_D = \frac{Vcc - V_F}{R_4} \qquad (6)$$

The current source $IP_2$ shown in Fig. 18 is useful in cases in which it is necessary to determine the input threshold voltage $V_{th}$ correctly.

Fig. 19 illustrates another possible current source structure for use in embodiments of the present invention. The current source $IP_3$ of Fig. 1a is formed by a resistor $R_4$, a resistor $R_5$, two diodes $D_7$ and $D_8$ connected in series between power source Vcc and GND, and transistor $Q_{11}$ whose base is connected to the anode of the diode $D_8$.

In Fig. 19, current $I'$ flowing through the transistor $Q_{11}$ is expressed by the following equation. ($V_{BE11}$ is the $V_{BE}$ of $Q_{11}$, $V_F$ is forward voltage of the diodes $D_8$, $D_9$)

$$I' = \frac{2V_F - V_{BE11}}{R_5} \qquad (7)$$

The current source $IP_3$ can allow input threshold voltage $V_{th}$ to be set correctly in spite of fluctuation of power source voltage Vcc.

An embodiment of the present invention can provide a bipolar logic circuit which generates an output signal having a stable waveform. The more current amplifying transistors the circuit has, the more will its output waveform be deformed if no current stabilising resistance is used. In view of this fact, a bipolar logic circuit embodying the present invention is useful because its output waveform is corrected or stabilised by the provision of as few as one current stabilising resistance. Further, even if a bipolar logic circuit embodying the invention has an IC structure as generally illustrated in Fig. 3, collector capacitance $C_C$ is no longer problematical, thus allowing various pattern arrangements. Moreover, the input threshold voltage of a bipolar logic circuit embodying this invention can be changed or selected over a wide range using only a simple structure, thus improving the degree of freedom available in design.

An embodiment of the present invention is uninfluenced by adjacent circuits even when it is a high density integration and high speed bipolar logic circuit, such as TTL or DTL, and disturbance of output waveforms due to parasitic capacitance is avoided, by the insertion of a resistor in the path between an emitter of a first current amplifying transistor and the base of a second amplifying transistor.

Moreover, an embodiment of the present invention can provide a bipolar logic circuit of which the input threshold voltage can be selected over a wide range by applying a current to the said resistor using a current source.

A bipolar logic circuit has a resistance (any of $RS_1$ to $RS_5$) connected between one current-amplifying transistor ($Q_1$ or $Q_2$) and a following current amplifying transistor ($Q_2$ or $Q_3$, respec-

tively). The resistance ($RS_1$ to $RS_5$) stabilises the output waveform of the circuit.

Alternative dispositions of the resistance within the circuit are allowed.

A current source ($IP_1$) for example constituted by a resistor ($R_1$) is provided.

Control of the current (I) delivered by the current source, and/or of the value of the resistance ($RS_1$ to $RS_5$) allows the input threshold voltage of the circuit to be selected.

## Claims

1. A bipolar TTL or DTL logic circuit, having an input stage (Q5, Q6; Q10; Q5, D5; D6, D5), a phase splitter transistor (Q7) and an output stage (Q8, Q9, D4), and having a resistance (RS', R'S) provided in the current path in the circuit, connecting the input stage to the phase splitter transistor, which determines the input threshold voltage of the logic circuit, a constant current source (IP1, R1, IP2, IP3) being connected between the said resistance and a power source voltage line (GND), so that current flowing through the constant current source is supplied to the said resistance whereby the voltage drop across said resistance is determined by the current flowing through the constant current source, so that the input threshold voltage of the logic circuit is determined in dependence upon the value of the said resistance and the value of the current flowing through the constant current source when the logic circuit is in use, the base of the phase-splitter transistor (Q7) being connected to the common connection part of the said resistance and the constant current source, and the output stage (Q8, Q9, D4) including an output transistor (Q8) having its base connected to the emitter of the phase splitter transistor (Q7).

2. A bipolar logic circuit as claimed in claim 1, wherein the said resistance (RS', R'S) is inserted between a further transistor (Q6, Q10), of the input stage, arranged for receiving signals from an input terminal (IN) and the base of the phase-splitter transistor (Q7).

3. A bipolar logic circuit as claimed in claim 1, wherein the said resistance (RS', R'S) is inserted between a diode (D5), of the input stage, arranged for receiving signals from the input terminal and the base of the phase-splitter transistor (Q7).

4. A bipolar logic circuit as claimed in claim 2 or 3, further comprising input means (Q5, D6) arranged between the input terminal (IN) and the said further transistor or the said diode.

5. A bipolar logic circuit as claimed in claim 2, wherein the said further transistor (Q10) is connected to the input terminal (IN).

6. A bipolar logic circuit as claimed in claim 4, wherein said input means is a diode (D6).

7. A bipolar logic circuit as claimed in claim 4, wherein said input means is a transistor (Q5).

8. A bipolar logic circuit as claimed in claim 5, wherein said input means is a pnp transistor (Q5).

9. A bipolar logic circuit as claimed in any preceding claim, wherein the constant current source comprises a resistor (R1) which is connected between the said resistance (RS', R'S) and a lower power source voltage line (GND).

10. A bipolar logic circuit as claimed in any one of claims 1 to 8, wherein the constant current source comprises a transistor (Q11, Fig. 18) having its collector connected to the said resistance (R'S), its emitter connected to a lower power source voltage line (GND), and its base connected to a higher power source voltage line (Vcc) via a resistor (R4), and a diode (D6) connected between the base of the transistor (Q11) of the constant current source and the lower power source voltage line (GND).

11. A bipolar logic circuit as claimed in any one of claims 1 to 8, wherein the constant current source comprises a transistor (Q11, Fig. 19) having its collector connected to the said resistance (R'S), its emitter connected to a lower power source voltage line (GND) via a resistor (R5), and its base connected to a higher voltage power source voltage line (Vcc) via another resistor (R4), and two diodes (D7, D8) connected in series between the base of the said transistor (Q11) of the constant current source and the lower power source voltage line (GND).

**Patentansprüche**

1. Bipolare TTL- oder DTL-Logikschaltung, mit einer Eingangsstufe (Q5, Q6; Q10; Q5, D5; D6, D5), einem Phasenteilertransistor (Q7) und einer Ausgangsstufe (Q8, Q9, D4), und mit einem Widerstand (RS', R'S), der in dem Stromweg in der Schaltung vorgesehen ist, die die Eingangsstufe mit dem Phasenteilertransistor verbindet, welcher die Eingangsschwellenspannung der Logikschaltung bestimmt, einer Konstantstromquelle (IP1, R1, IP2, IP3), die zwischen dem genannten Widerstand und einer Energiequellenspannungsleitung (GND) angeordnet ist, so daß ein Strom, der durch die Konstantstromquelle fließt, dem genannten Widerstand zugeführt wird, wodurch der Spannungsabfall quer an dem genannten Widerstand bestimmt wird durch den Strom, der durch die Konstantstromquelle fließt, so daß die Eingangsschwellenspannung der Logikschaltung bestimmt ist in Abhängigkeit von dem Wert des genannten Widerstands und dem Wert des Stromes, der durch die Konstantstromquelle fließt, wenn die Logikschaltung in Benutzung ist, wobei die Basis des Phasenteilertransistors (Q7) mit dem gemeinsamen Verbindungsteil des genannten Widerstands und der Konstantstromquelle verbunden ist, und die Ausgangsstufe (Q8, Q9, D4) einen Ausgangstransistor (Q8) umfaßt, dessen Basis mit dem Emitter des Phasenteilertransistors (Q7) verbunden ist.

2. Bipolare Logikschaltung nach Anspruch 1, bei der der genannte Widerstand (RS', R'S) zwischen einem weiteren Transistor (Q6, Q10), der Eingangsstufe, der zum Empfang von Signalen von einem Eingangsanschluß (IN) angeordnet ist, und der Basis des Phasenteilertransistors (Q7), eingefügt ist.

3. Bipolare Logikschaltung nach Anspruch 1, bei der der genannte Widerstand (RS', R'S) eingefügt ist zwischen einer Diode (D5) der Eingangsstufe, die zum Empfang von Signalen von einem Eingangsanschluß angeordnet ist, und der Basis des Phasenteilertransistors (Q7).

4. Bipolare Logikschaltung nach Anspruch 2 oder 3, ferner mit einer Eingangseinrichtung (Q5, D6), die zwischen dem Eingangsanschluß (IN) und dem genannten weiteren Transistor oder der genannten Diode angeordnet ist.

5. Bipolare Logikschaltung nach Anspruch 2, bei der der genannte weitere Transistor (Q10) mit dem Eingangsanschluß (IN) verbunden ist.

6. Bipolare Logikschaltung nach Anspruch 4, bei der die genannte Eingangseinrichtung eine Diode (D6) ist.

7. Bipolare Logikschaltung nach Anspruch 4, bei der die genannte Eingangseinrichtung ein Transistor (Q5) ist.

8. Bipolare Logikschaltung nach Anspruch 5, bei der die genannte Eingangseinrichtung ein pnp-Transistor (Q5) ist.

9. Bipolare Logikschaltung nach einem der vorhergehenden Ansprüche, bei der die Konstantstromquelle einen Widerstand (R1) umfaßt, der zwischen dem genannten Widerstand (RS', R'S) und einer Spannungsleitung einer niedrigeren Energiequelle (GND) angeschlossen ist.

10. Bipolare Logikschaltung nach einem der Ansprüche 1 bis 8, bei der die Konstantstromquelle einen Transistor (Q11, Fig. 18) umfaßt, dessen Kollektor mit dem genannten Widerstand (R'S) verbunden ist, dessen Emitter mit einer Spannungsleitung einer niedrigeren Energiequelle (GND) verbunden ist und dessen Basis mit einer Spannungsleitung (Vcc) einer höheren Energiequelle über einen Widerstand (R4) verbunden ist, und eine Diode (D6), die zwischen der Basis des Transistors (Q11) der Konstantstromquelle und der Spannungsleitung der niedrigeren Energiequelle (GND) verbunden ist.

11. Bipolare Logikschaltung nach einem der Ansprüche 1 bis 8, bei der die Konstantstromquelle einen Transistor (Q11, Fig. 19) umfaßt, dessen Kollektor mit dem genannten Widerstand (R'S) verbunden ist, dessen Emitter mit einer Spannungsleitung einer niedrigeren Energiequelle (GND) über einen Widerstand (R5) verbunden ist und dessen Basis mit einer Spannungsleitung einer höheren Energiequelle (Vcc) über einen anderen Widerstand (R4) verbunden ist, und zwei Dioden (D7, D8), die in Reihe zwischen der Basis des genannten Transistors (Q11) der Konstantstromquelle und der Spannungsleitung der niedrigeren Energiequelle (GND) verbunden sind.

**Revendications**

1. Circuit logique bipolaire TTL ou DTL, comprenant un étage d'entrée (Q5, Q6; Q10; Q5, D5; D6, D5), un transistor séparateur de phase (Q7) et un étage de sortie (Q8, Q9, D4), et comprenant une résistance (RS', R'S) prévue dans le circuit de courant dans le circuit, connectant l'étage d'entrée au transistor séparateur de phase, qui détermine la tension seuil d'entrée du circuit logique, une source de courant constant (IP1, R1, IP2, IP3) étant connectée entre ladite résistance et une ligne de tension d'alimentation (GND) de manière qu'un courant qui circule par la source de courant constant soit fourni à ladite résistance afin que la chute de tension aux bornes de ladite résistance soit déterminée par le courant qui circule par la source de courant constant, de sorte que la tension seuil d'entrée du circuit logique est déterminée en fonction de la valeur de ladite résistance et de la valeur du courant qui circule par la source de courant constant quand le circuit logique est en utilisation, la base du transistor séparateur de phase (Q7) étant connectée à la partie de connexion commune de ladite résistance et de la source de courant constant et l'étage de sortie (Q8, Q9, D4) comportant un transistor de sortie (Q8) dont la base est connectée à l'émetteur du transistor séparateur de phase (Q7).

2. Circuit logique bipolaire selon la revendication 1, dans lequel ladite résistance (RS', R'S) est intercalée entre un autre transistor (Q6, Q10) de l'étage d'entrée, agencé pour recevoir des signaux d'une borne d'entrée (IN), et la base du transistor séparateur de phase (Q7).

3. Circuit logique bipolaire selon la revendication 1, dans lequel ladite résistance (RS', R'S) est intercalée entre une diode (D5) de l'étage d'entrée, agencée pour recevoir des signaux de la borne d'entrée, et la base du transistor séparateur de phase (Q7).

4. Circuit logique bipolaire selon la revendication 2 ou 3, comportant en outre un dispositif d'entrée (Q5, D6) disposé entre la borne d'entrée (IN) et ledit autre transistor ou ladite diode.

5. Circuit logique bipolaire selon la revendication 2, dans lequel ledit autre transistor (Q10) est connecté à la borne d'entrée (IN).

6. Circuit logique bipolaire selon la revendication 4, dans lequel ledit dispositif d'entrée est une diode (D6).

7. Circuit logique bipolaire selon la revendication 4, dans lequel ledit dispositif d'entrée est un transistor (Q5).

8. Circuit logique bipolaire selon la revendication 5, dans lequel ledit dispositif d'entrée est un transistor PNP (Q5).

9. Circuit logique bipolaire selon l'une quelconque des revendications précédentes, dans lequel la source de courant constant comporte une résistance (R1) qui est connectée entre ladite résistance (RS', R'S) et une ligne de tension d'alimentation inférieure (GND).

10. Circuit logique bipolaire selon l'une quelconque des revendications 1 à 8, dans lequel la source de courant constant comporte un transistor (Q11, figure 18) dont le collecteur est connecté à ladite résistance (R'S), dont l'émetteur est connecté à une ligne de tension d'alimentation inférieure (GND) et dont la base est connectée à une ligne d'alimentation supérieure (Vcc) par une résistance (R4), et une diode (D6) connectée entre la base du transistor (Q11) de la source de courant constant et la ligne de tension d'alimentation inférieure (GND).

11. Circuit logique bipolaire selon l'une quelconque des revendications 1 à 8, dans lequel la source de courant constant comporte un transistor (Q11, figure 19) dont le collecteur est connecté à ladite résistance (R'S), dont l'émetteur est connecté à la ligne de tension d'alimentation inférieure (GND) par une résistance (R5) et dont la base est connectée à une ligne de tension d'alimentation supérieure (Vcc) par une autre résistance (R4), et deux diodes (D7, D8) connectées en série entre la base dudit transistor (Q11) de la source de courant constant et la ligne de tension d'alimentation inférieure (GND).

Fig. 1

Fig. 2

Fig. 3 A

Fig. 3 B

# Fig. 4

# Fig. 5

# Fig. 6

Fig. 7

Fig. 8

Fig. 9

3

Fig. 10

(a)

(b)

Fig. 11

Fig. 12

Fig. 13

Fig. 14

Fig. 15

(a)

(b)

Fig. 16

(a)

(b)

Fig. 17

(a)

(b)

Fig. 18

Fig. 19